# EUROPEAN PATENT APPLICATION

(11) **EP 2 135 970 A1**
(43) Date of publication of application: **23.12.2009**
(21) Application number: 08158674.5
(22) Date of filing: 20.06.2008
(51) Int. Cl.: C23C 14/04, C23C 14/56

(54) **Processing system and method for processing a substrate**

(71) Applicant: Applied Materials, Inc., Santa Clara, CA 95054 (US)
(72) Inventor: Dieguez-Campo, Jose Manuel, 63457, Hanau (DE); König, Michael, 60529, Frankfurt / Main (DE); Stahr, Frank, 01477, Arnsdorf (DE)
(74) Representative: Lermer, Christoph

(57) **Abstract**

A coating system 1 comprises a vacuum coating chamber 2 (recipient), a lock chamber 3 coupled to the vacuum coating chamber 2 and a handling robot 4 for handling substrate carriers 5. Furthermore, the coating system 1 may comprise a transport or conveyer system 6 for delivering substrates 7 to the coating system 1 and / or coated substrates 7 away from the coating system 1. Moreover, the coating system 1 may comprise an inkjet printer 8 for printing a pattern, e.g. of a resist material, on the surface of a substrate 7. The vacuum coating chamber 2 comprises a housing 21 defining an inner space 22 of the vacuum coating chamber 2. In the inner space 22 of the vacuum coating chamber 2 a shadow mask 23 is fixedly installed. Furthermore, the vacuum coating chamber 2 comprises coating tools (not shown), e.g. for providing a CVD coating process in the inner space 22 of the vacuum coating chamber 2. According to the invention a coating system 1 comprises a plasma source schematically indicated by reference number 26 which is arranged in the inner space 22 of the coating chamber 2. While there is no substrate in the inner space 22 of the coating chamber 2 a plasma is generated in the vicinity of the shadow mask 23 for providing a cleaning process to clean the shadow mask 23 by means of a plasma chemical process. Therefore, there is no need to fix a mask to the carrier before starting the coating process, and to remove the mask from the carrier after terminating the coating process, thus avoiding handling steps and contamination of the substrate attached to the substrate carrier by particles released from the mask.

## Description

### TECHNICAL FIELD

The present invention relates to a processing system for processing a substrate comprising a process chamber for receiving said substrate in said process chamber. Furthermore, the invention relates to a method for processing a substrate comprising a step of providing a processing system as mentioned above.

### BACKGROUND OF THE INVENTION

In a number of technical applications thin material layers are deposited on a substrate for generating a one layer or a multi layer system. For depositing the layers on a substrate various methods may be used, e.g. CVD (Chemical Vapor Deposition), PVD (Physical Vapor Deposition), evaporation, sputtering, etc.

A one layer or multi layer electronic device, e.g. an OLED (Organic Light Emitting Diode) device, for instance an OLED panel or screen, may be exposed to environmental influences. In order to protect the device against these influences a protective element is provided on top of the layer and the layer system, respectively. For example, a combination of a glass panel and a getter system for gettering humidity may be glued on top of the layer system.

Alternatively, for sealing the electronic device it is possible to deposit a protective layer stack on top of a functional layer and layer system, respectively. The protective and/or barrier layer(s) may be deposited by means of a CVD deposition process. Sometimes it may be required to form a structure or a pattern in the protective layer(s). Thus, shadow masks may be used for covering portions of the surface of the substrate during the coating process. A shadow mask is usually positioned and aligned relative to the substrate outside a coating chamber before the coating process, the substrate being positioned in a substrate carrier.

Due to the fact that a plurality of layers of different materials may have different patterns a respective shadow mask may have to be removed after each deposition step and be replaced by another respective shadow mask. Manufacturing the protective layer stack may thus involve a lot of handling effort regarding the handling of the substrates, the shadow masks and the substrate/mask carriers. Furthermore, handling of substrates is a source for the generation of particles which may involve contamination of a layer and constrict the production of an effective protective layer stack.

### OBJECT OF THE INVENTION

It is an object of the present invention to provide a coating system and a method for processing a substrate requiring less handling effort, particularly when producing a patterned sealing layer stack, particularly on top of an OLED device.

### TECHNICAL SOLUTION

This object is achieved by the provision of a processing system according to claim 1 and a method for processing a substrate according to claim 10. The dependent claims refer to features of preferred embodiments of the invention.

The inventive processing system for processing a substrate comprises: a process chamber for receiving said substrate in said process chamber; a patterning device installed within said process chamber; and a means for transferring said substrate into said process chamber and for aligning said substrate relative to said patterning device.

The processing system may be a coating system for depositing a protective layer or a protective layer stack, e. g. on top of an OLED layer or layer system. The coating process may be any conventional process, e.g. CVD, PVD, evaporation, sputtering, etc. The process chamber may be a coating chamber for the respective coating process.

The patterning device may be a shadow mask, e.g. for use in a CVD coating process. According to the present invention, the patterning device is installed and particularly fixedly arranged within the process chamber. Before processing the substrate is arranged in a substrate carrier and transferred into the process chamber. A carrier or a plurality of carriers may be transported into a particular coating chamber. Afterwards, the carrier and/or the substrate are moved towards the shadow mask and aligned in front of the shadow mask. A lifting device may be used to lift the carrier and/or the substrate towards the shadow mask. The substrate may be aligned relative to the patterning device e.g. by means of pins and corresponding receivers for the pins provided at the carrier and in the coating chamber, respectively. In the coating chamber a layer of a particular material having a particular pattern is deposited on the surface of the substrate(s).

After the deposition of a particular layer, the substrate is removed from the shadow mask, e.g. by lowering the substrate, and removed from the process chamber. At this stage, the shadow mask remaining located within the coating chamber is cleaned by a plasma treatment within the chamber before the next coating process is carried out in the chamber.

By means of the invention it is possible to provide a patterned/structured layer, e.g. by using a CVD coating method, wherein the shadow mask remains in the coating chamber after the layer has been deposited on the substrate. There is no need to adjust a shadow mask relative to a substrate attached to a carrier and attach the mask to the carrier outside a coating chamber, and to remove the mask after a particular coating step outside the coating chamber. Therefore, contamination of the protective layer stack by particles released from the mask during a handling step may be avoided.

In the meantime the shadow mask remains within the coating chamber in a vacuum atmosphere after the particular coating step has been terminated. It is possible to clean the mask, e.g. by a providing plasma in the vicinity of the patterning device, before processing another substrate. The cleaning process may be carried out as soon as the substrates have been removed from the coating chamber, e.g. into a lock chamber which may be evacuated and/or vented while cleaning the mask.

By means of the invention, the effectiveness of the system, i.e. the cycle time/uptime of the system, may be improved. Furthermore, due to plasma cleaning of the mask between two coating steps the quality of the pattern and the purity and perfection of the layer stack may be improved.

In a preferred embodiment of the invention, the processing system comprises a plasma source for providing a plasma in the vicinity of the patterning device for cleaning the patterning device. The plasma source is arranged within the process chamber. The plasma cleaning step is usually carried out between two processing/coating steps.

Particularly, said means is configured to move the substrate relative to the patterning device at least from a transfer position into a processing position. A relative movement comprises moving the substrate and/or the patterning device to align the substrate relative to the patterning device. The transfer position may be a position inside or outside the process chamber. The processing position is a position inside the process chamber wherein the substrate is usually positioned close to the shadow mask for depositing a patterned layer on the surface of a substrate.

It is preferred that said means comprises at least a handling system for moving the substrate relative to the patterning device in the process chamber and to transfer the substrate from the transfer position into the processing position. The handling system may comprise e.g. a robot arm having means for engaging corresponding means provided at the substrate carriers for receiving, releasing, lifting, and/or lowering the substrate carrier and/or the substrate. The present invention is, however, not limited to a particular handling and/or transport system, but may be implemented with any handling and/or transport system which provides a movement of a substrate from the transfer position into the processing position.

In a preferred embodiment of the invention, the processing system comprises at least a substrate carrier for carrying at least a substrate. The substrate may be attached to a substrate carrier particularly outside the process chamber.

Particularly, the substrate carrier and/or the process chamber comprise said means for aligning said substrate relative to the patterning device. Said means for aligning may comprise a guidance, pins and corresponding cavities for receiving the pins, etc.

In a preferred embodiment of the invention, said means for transferring the substrate comprises means for lifting and/or lowering the substrate. Said means for lifting and/or lowering the substrate may be provided e. g. in a handling arm. For example, the means may comprise a drive for actuating lifting pins provided in the substrate carrier for lifting and/or lowering a substrate carrier and/or the substrate.

In another preferred embodiment of the invention the processing system may comprise a lock chamber coupled to the process chamber.

The method for processing a substrate according to the invention comprises the steps of: a) providing a processing system as described above; b) transferring a substrate into the process chamber; c) moving the substrate relative to the patterning device from a transfer position into a coating position; d) processing the substrate; e) removing the substrate from the process chamber; and f) providing plasma cleaning of the patterning device arranged in the process chamber. Method step e) is usually carried out while the coated substrate is locked out of the coating system via a lock chamber and/or while a new substrate to be coated is locked in the coating system via a lock chamber. Therefore time used for evacuating and venting the lock chamber may be used for plasma cleaning the mask.

In a preferred embodiment of the invention, method step c) includes aligning the substrate relative to the patterning device.

It is also preferred that said method step c) includes moving/lifting the substrate towards the patterning device to arrange the substrate in the vicinity of the patterning device in the coating position. The mask may be fixedly arranged within the chamber, or it may be moveably arranged within the chamber. Either the substrate or the mask, or both the substrate and the mask may be moved such that the substrate is finally in the processing position relative to the mask.

Particularly, the method step e) includes moving the substrate away/lowering the substrate from the patterning device and/or transferring the substrate out of the process chamber.

The method according to the invention comprises repeating steps b) to e) to process another substrate. It may particularly comprise repeating steps b) to f) to process another substrate and clean the mask after every coating process in a cycle of n = 0, 1, 2, 3, ... repetitions of steps b) to f).

The features described above are meant to be protected by themselves or in any combination with the described device and/or method features.

### BRIEF DESCRIPTION OF THE DRAWINGS

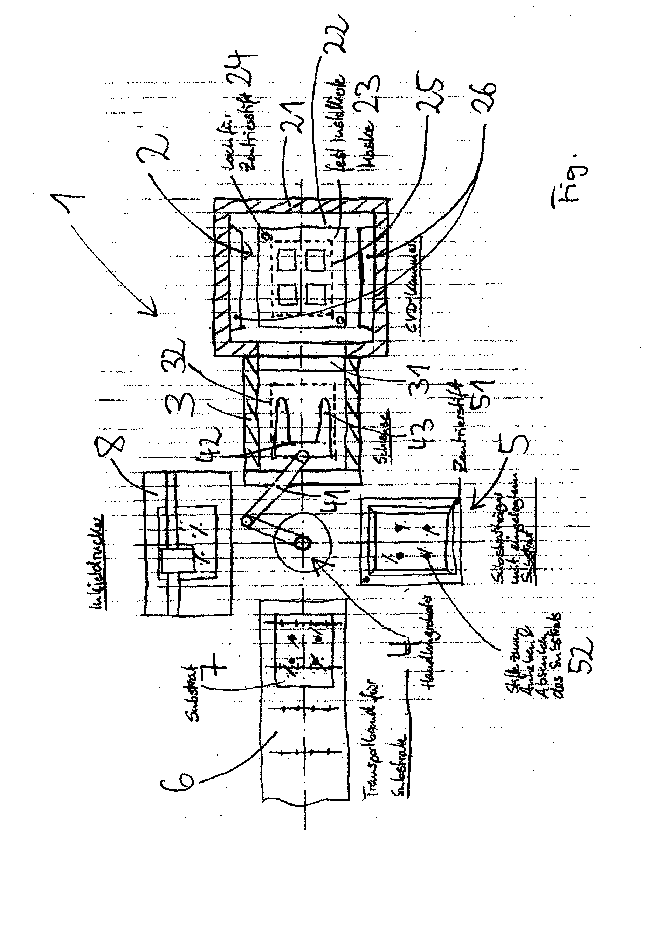

Further objects and advantages result from the following description of a specific embodiment. The figure shows a schematic top view of an embodiment of a coating system according to the invention.

### DESCRIPTION OF A SPECIFIC EMBODIMENT

The figure illustrates an embodiment of a coating system 1 according to the invention.

The coating system 1 comprises a vacuum coating chamber 2 (recipient), a lock chamber 3 coupled to the vacuum coating chamber 2 and a handling robot 4 for handling substrate carriers 5. Furthermore, the coating system 1 may comprise a transport or conveyer system 6 for delivering substrates 7 to the coating system 1 and / or coated substrates 7 away from the coating system 1. Moreover, the coating system 1 may comprise an inkjet printer 8 for printing a pattern, e.g. of a polymer material, on the surface of a substrate 7.

The vacuum coating chamber 2 comprises a housing 21 defining an inner space 22 of the vacuum coating chamber 2. In the inner space 22 of the vacuum coating chamber 2 a shadow mask 23 is fixedly installed. Furthermore, the vacuum coating chamber 2 comprises coating tools (not shown), e.g. for providing a CVD coating process in the inner space 22 of the vacuum coating chamber 2.

The shadow mask 23 has pin holes 24 for receiving adjustment pins 51 provided at a substrate carrier 5 for adjusting a substrate 7 attached to a carrier 5 relative to the mask 23 in a coating position indicated by dashed lines 25. According to the invention a coating system 1 comprises a plasma source schematically indicated by reference number 26 which is arranged in the inner space 22 of the coating chamber 2. While there is no substrate in the inner space 22 of the coating chamber 2 a plasma is generated in the vicinity of the shadow mask 23 for providing a cleaning process to clean the shadow mask 23 by means of a plasma chemical process. Particles removed from the mask 23 during the cleaning process are removed from inner space 22 of the coating chamber 2 before carrying out another coating process. The particles removed from the mask 23 in the cleaning process are gaseous reaction products which may be removed from the inner space 22 of the coating chamber 2 by means of a vacuum pump system (not shown).

The lock chamber 3 is coupled to the coating chamber 2 via a gate valves 31. The lock chamber 3 provides for transferring substrates from an atmospheric pressure outside the lock chamber into a vacuum atmosphere provided in the inner space 22 of the coating chamber 2, and vice versa. In dashed lines a transfer position 32 is indicated in which a substrate is held during an evacuation and / or venting process of the lock chamber 3.

The handling robot 4 comprises a drive (not shown) for driving a robot arm 41 which is connected with a support element 42 for supporting a substrate carrier 5 and/or a substrate 7. The support element 42 has a lifting mechanism 43 for interacting with lifting pins 52 provided at the substrate carrier 5 in order to lift the carrier 5 (and thus the substrate 7 attached to the carrier 5) into the coating position 25 arranged in the inner space 22 of the coating chamber 2.

Before the substrate carrier 5 is transported into the lock chamber by means of the handling robot 4 a substrate 7 received from the transport conveyer 6 is attached to the substrate carrier 5. As mentioned above the substrate carrier 5 comprises adjustment pins 51 for engagement with corresponding pin holes 24 provided at the mask 23, and lifting pins 52 for interacting with a lifting mechanism 43 provided at the handling robot 4 for lifting a substrate from a transfer position into the coating position 25.

According to the invention the shadow mask 23 remains in the inner space 22 of the coating chamber 2 during a number of coating cycles. Between the coating steps the mask 23 may be cleaned by a plasma cleaning system 26 which is also provided within the inner space 22 of the vacuum coating chamber 2.

Therefore, there is no need to fix a mask to the carrier before starting the coating process, and to remove the mask from the carrier after terminating the coating process, thus avoiding handling steps and contamination of the substrate attached to the substrate carrier by particles released from the mask.

## Claims

1. A processing system (1) for processing a substrate (7) comprising a process chamber (2) for receiving said substrate (7) in said process chamber (2);
**characterized in that**
said processing system (1) comprises a patterning device (23) installed within said process chamber (2); and a means (4, 43, 52, 24, 51) for transferring said substrate (7) into said process chamber (2) and for aligning said substrate (7) relative to said patterning device (23).

2. The processing system (1) according to claim 1,
**characterized in that**
said processing system (1) comprises a plasma source (26) for providing a plasma in the vicinity of said patterning device (23) for cleaning said patterning device (23).

3. The processing system (1) according to claim 1 or 2,
**characterized in that**
said means (4, 43, 52, 24, 51) for transferring said substrate (7) into said process chamber (2) and for aligning said substrate (7) relative to said patterning device (23) is configured to move said substrate relative to said patterning device (23) at least from a transfer position (32) into a processing position (25).

4. The processing system (1) according to claim 3,
**characterized in that**
said means (4, 43, 52, 24, 51) for transferring said substrate (7) into said process chamber (2) and for aligning said substrate (7) relative to said patterning device (23) comprises at least a handling system (4).

5. The processing system (1) according to claim 4,
**characterized in that**
said handling system (4) comprises means for receiving, releasing, lifting, and/or lowering a substrate (7).

6. The processing system (1) according to any of the previous claims,
**characterized in that**
said processing system (1) comprises at least a substrate carrier (5) for carrying at least a substrate (7).

7. The processing system (1) according to claim 6,
**characterized in that**
said substrate carrier (7) and/or said process chamber (2) comprises said means (24, 51) for aligning said substrate (7) relative to said patterning device (23).

8. The processing system (1) according to any of the previous claims,
**characterized in that**
said means (4, 43, 52) for transferring said substrate (7) comprises means (43, 52) for lifting and/or lowering said substrate (7).

9. The processing system (1) according to any of the previous claims,
**characterized in that**
said processing system (1) comprises a lock chamber (3) coupled to said process chamber (2).

10. A method for processing a substrate (7) comprising the steps of:
a) providing a processing system (1) according to any of the previous claims;
b) transferring a substrate (7) into said process chamber (2);
c) moving said substrate (7) relative to said patterning device (23) from a transfer position (32) into a coating position (25);
d) processing said substrate (7);
e) removing said substrate (7) from said process chamber (2); and
f) providing plasma cleaning of said patterning device (23) arranged in said process chamber (2).

11. The method according to claim 10,
**characterized in that**
said method step c) includes aligning said substrate (7) relative to said patterning device (23).

12. The method according to claim 10 or 11,
**characterized in that**
said method step c) includes moving/lifting said substrate (7) towards said patterning device (2) to arrange said substrate (7) in the vicinity of said patterning device (23) in said coating position (25).

13. The method according to claim 10, 11 or 12,
**characterized in that**
said method step e) includes moving said substrate (7) away/lowering said substrate (7) from said patterning device (23) and transferring said substrate (7) out of said process chamber (2).

14. The method according to claim 10, 11, 12 or 13,
**characterized in that**
said method comprises repeating steps b) to f) to process another substrate.

## Amended claims

### Amended claims in accordance with Rule 137(2) EPC.

**1.** A processing system (1) for processing a substrate (7) comprising a process chamber (2) for receiving said substrate (7) in said process chamber (2);
said processing system (1) comprises a patterning device (23) installed within said process chamber (2); and
a plasma source (26) for providing a plasma in the vicinity of said patterning device (23) for cleaning said patterning device (23),
**characterized in that**
said processing system (1) comprises a means (4, 43, 52, 24, 51) for transferring said substrate (7) into said process chamber (2) and for aligning said substrate (7) relative to said patterning device (23).

**2.** The processing system (1) according to claim 1,
**characterized in that**
said means (4, 43, 52, 24, 51) for transferring said substrate (7) into said process chamber (2) and for aligning said substrate (7) relative to said patterning device (23) is configured to move said substrate relative to said patterning device (23) at least from a transfer position (32) into a processing position (25).

**3.** The processing system (1) according to claim 2,
**characterized in that**
said means (4, 43, 52, 24, 51) for transferring said substrate (7) into said process chamber (2) and for aligning said substrate (7) relative to said patterning device (23) comprises at least a handling system (4).

**4.** The processing system (1) according to claim 3,
**characterized in that**
said handling system (4) comprises means for receiving, releasing, lifting, and/or lowering a substrate (7).

**5.** The processing system (1) according to any of the previous claims,
**characterized in that**
said processing system (1) comprises at least a substrate carrier (5) for carrying at least a substrate (7).

**6.** The processing system (1) according to claim 5,
**characterized in that**
said substrate carrier (7) and/or said process chamber (2) comprises said means (24, 51) for aligning said substrate (7) relative to said patterning device (23).

**7.** The processing system (1) according to any of the previous claims,
**characterized in that**
said means (4, 43, 52) for transferring said substrate (7) comprises means (43, 52) for lifting and/or lowering said substrate (7).

**8.** The processing system (1) according to any of the previous claims,
**characterized in that**
said processing system (1) comprises a lock chamber (3) coupled to said process chamber (2).

**9.** A method for processing a substrate (7) comprising the steps of:
a) providing a processing system (1) according to any of the previous claims;
b) transferring a substrate (7) into said process chamber (2);
c) moving said substrate (7) relative to said patterning device (23) from a transfer position (32) into a coating position (25) and aligning said substrate (7) relative to said patterning device (23);
d) processing said substrate (7);
e) removing said substrate (7) from said process chamber (2); and
f) providing plasma cleaning of said patterning device (23) arranged in said process chamber (2).

**10.** The method according to claim 9,
**characterized in that**
said method step c) includes moving/lifting said substrate (7) towards said patterning device (2) to arrange said substrate (7) in the vicinity of said patterning device (23) in said coating position (25).

**11.** The method according to claim 9 or 10,
**characterized in that**
said method step e) includes moving said substrate (7) away/lowering said substrate (7) from said patterning device (23) and transferring said substrate (7) out of said process chamber (2).

**12.** The method according to claim 9, 10, or 11,
**characterized in that**
said method comprises repeating steps b) to f) to process another substrate.
